## (19) Europäisches Patentamt
European Patent Office
Office européen des brevets

(11) **EP 1 018 216 B1**

(12) **EUROPÄISCHE PATENTSCHRIFT**

(45) Veröffentlichungstag und Bekanntmachung des Hinweises auf die Patenterteilung:
**24.07.2002 Patentblatt 2002/30**

(21) Anmeldenummer: **98952549.8**

(22) Anmeldetag: **08.09.1998**

(51) Int Cl.⁷: **H03H 17/02**, H03H 17/06

(86) Internationale Anmeldenummer:
**PCT/DE98/02651**

(87) Internationale Veröffentlichungsnummer:
**WO 99/17446 (08.04.1999 Gazette 1999/14)**

(54) **FILTER ZUR ZEITMULTIPLEXFILTERUNG MEHRERER DATENFOLGEN UND BETRIEBSVERFAHREN DAFÜR**

FILTER FOR TIME MULTIPLEX FILTERING OF SEVERAL DATA SEQUENCES AND OPERATIONAL METHOD THEREFOR

FILTRE POUR FILTRAGE DE PLUSIEURS SEQUENCES DE DONNEES EN MULTIPLEXAGE TEMPOREL, ET PROCEDE PERMETTANT DE FAIRE FONCTIONNER CE FILTRE

(84) Benannte Vertragsstaaten:
**DE ES FR GB IT**

(30) Priorität: **26.09.1997 DE 19742599**

(43) Veröffentlichungstag der Anmeldung:
**12.07.2000 Patentblatt 2000/28**

(73) Patentinhaber: **Micronas Munich GmbH 81541 München (DE)**

(72) Erfinder:
• **WENDEL, Dirk**
  **D-82008 Unterhaching (DE)**
• **MEHRGARDT, Sönke**
  **D-82041 Deisenhofen (DE)**
• **NIE, Xiaoning**
  **D-85591 Vaterstetten (DE)**

(74) Vertreter: **Patentanwälte Westphal, Mussgnug & Partner Mozartstrasse 8 80336 München (DE)**

(56) Entgegenhaltungen:
**EP-A- 0 137 464**

**Beschreibung**

Die vorliegende Erfindung betrifft eine Vorrichtung und ein Verfahren zur Filterung einer Mehrzahl von Datenfolgen im Zeitmultiplex. Eine solche Vorrichtung ist zum Beispiel aus dem EP.A. 0 137 464 bekannt.

Es gibt eine Vielzahl von Anwendungen, bei denen zwei oder mehr digitale Datenströme oder -folgen in gleicher Weise gefiltert werden müssen. Z.B. kann es in der Fernsehtechnik nötig sein, Datentripel wie etwa Folgen von RGB- oder YUV-Daten um den gleichen Faktor zu dezimieren.

Ferner kann es bei der Multiplex-Übertragung einer Mehrzahl von Datenfolgen über einen gemeinsamen Kanal notwendig werden, die Bandbreite der Datenfolgen durch eine für alle Folgen einheitliche Tiefpaßfilterung an die Übertragungsbandbreite des Kanals anzupassen. Die in jeder Datenfolge vorhandene maximale Frequenz darf nicht höher sein als das $(1/2n)$-fache der Abtastfrequenz bzw. der Übertragungsfrequenz des Kanals. Andernfalls kommt es zu Störungen, die als Alias bezeichnet werden.

Um diese Störungen so gering wie möglich zu halten, ist es üblich, die Datenfolgen vor ihrer Übertragung über den Kanal einzeln tiefpaßzufiltern. Nach der Filterung wird aus den mehreren Datenfolgen mit Hilfe eines Umschalters eine neue Folge gebildet, die zyklisch aus Werten der verschiedenen Ausgangsfolgen zusammengesetzt ist und über den Kanal übertragen werden kann.

Die hierfür verwendeten Tiefpässe haben z. B. Übertragungsfunktionen der Form

$$H(z^{-1}) = (1-z^{-1})^m$$

und bestehen aus einer Reihenschaltung von Register-Addierer-Einheiten, bei denen die Eingänge der Addierer jeweils einmal direkt und einmal über ein Verzögerungsregister mit dem Eingang der Einheit verbunden sind. Ein solches Filter ist in Fig. 11 gezeigt.

Diese herkömmlichen Filter bestimmen, bedingt durch ihren Aufbau, zu jedem eingegebenen Wert einer ursprünglichen Folge einen Ausgabewert. Dabei ist möglich, daß aufgrund einer begrenzten Übertragungskapazität des Übertragungskanals nur ein Teil dieser Werte abgenommen werden kann, die übrigen also umsonst bestimmt werden.

Aufgabe der Erfindung ist, ein Filter und ein Verfahren zum Betreiben des Filters anzugeben, die es gestatten, den mit der Vorhaltung eines eigenen Filters für jede ursprüngliche Datenfolge verbundenen Schaltungsaufwand zu verringern und so die für die Integration solcher Filter benötigte Substratfläche zu minimieren.

Die Aufgabe wird zum einen gelöst durch ein Filter nach Anspruch 1. Die Struktur dieses Filters gestattet es, eine Mehrzahl von Datenfolgen gleichzeitig in ein und demselben Filter zu verarbeiten, wobei zu jedem Zeitpunkt die Register einer Gruppe nur Werte enthalten, die von den Werten einer einzigen der ursprünglichen Folgen abgeleitet sind.

Jedesmal, wenn die Register des Filters aktiviert werden, um die an ihrem Eingang anliegenden Werte zu speichern, wandern diese Werte zur nächsten Gruppe weiter, ohne dabei von den Werten anderer Folgen beeinflußt zu werden.

Ein erfindungsgemäßes Filter mit polynomartiger Übertragungsfunktion $H(z^{-1})=\Sigma a_j \, z^{-j}$ läßt sich als Reihenschaltung von m Register-Addierer-Einheiten aufbauen, wobei der erste Eingang der nullten Einheit mit dem zugeordneten Signalkanal und die ersten Eingänge aller anderen Einheiten mit dem Ausgang der unmittelbar vorangehenden Einheit verbunden sind.

Ein erfindungsgemäßes Filter ist einfach zu konstruieren, indem für alle Faktoren $a_j \neq 1$ der Übertragungsfunktion ein Multiplizierer zum Multiplizieren mit dem Faktor aj vorgesehen wird, der den zweiten Eingang der j-ten Einheit mit dem zugehörigen Datenkanal verbindet.

Multiplizierer zum Multiplizieren mit einer Zweierpotenz 2j lassen sich auf sehr einfache Weise durch einen Submultiplizierer bilden, der lediglich eine Datenleitung enthält, deren Bit-Eingänge jeweils mit um j Bits höherwertigen Ausgängen verknüpft sind.

Multiplizierer zum Multiplizieren mit einem beliebigen Faktor können aus einer Mehrzahl von Submultiplizierern entsprechend den in dem Faktor enthaltenen Zweierpotenzen und Addierern zum Addieren der Ausgaben der Submultiplizierer aufgebaut sein.

Zweckmäßigerweise umfaßt das Filter ferner einen Multiplexer mit n Eingängen für die n Datenfolgen und n Ausgängen, an die jeweils einer der n Signalkanäle angeschlossen ist, wobei der Multiplexer eingerichtet ist, Datenwerte einer der Datenfolgen im zyklischen Wechsel auf die verschiedenen Datenkanäle auszugeben.

Zum Auseinandersortieren von aus jeweils Verschiedenen Datenfolgen hergeleiteten gefilterten Werten kann als Ausgangsstufe des Filters, ggf. hinter der Übertragungsstrecke, ein Demultiplexer vorgesehen werden, der an den Ausgang einer der Einheiten angeschlossen ist und n Ausgänge aufweist, die jeweils einen einer der Datenfolgen zugeordneten Ausgang des Filters bilden.

Die Aufgabe wird des weiteren gelöst durch ein Verfahren nach Anspruch 9. Dieses Verfahren ist insbesondere vorteilhaft anwendbar auf ursprüngliche Datenfolgen mit gleichen Taktraten.

Die Ausgabedatenrate des Filters ist in Anpassung an die Übertragungskapazität des Übertragungskanals weitgehend frei wählbar. Wenn die Verfahrensschritte a) bis c) in jeder Taktperiode der ursprünglichen Datenfolgen n-mal durchgeführt werden, wird zu jedem eingegebenen Ursprungsdatenwert ein gefilterter Wert erzeugt. Wenn die Schritte nur einmal pro Taktperiode ausgeführt werden, so entspricht dies einer Dezimation der ursprünglichen Daten um den Faktor n. In jedem Fall, unabhängig von der Zahl der Wiederholungen, werden aber mit dem erfindungsgemäßen Filter nicht mehr Datenwerte erzeugt als tatsächlich auf den Übertragungskanal ausgegeben werden und so der mit den herkömmlichen Filtern bei der Dezimation der Daten vor ihrer Übertragung verbundene überflüssige Rechenaufwand vermieden.

Weitere Merkmale und Vorteile der Erfindung ergeben sich aus der nachfolgenden Beschreibung von Ausführungsbeispielen unter Bezugnahme auf die beigefügten Figuren. Es zeigen:

Fig. 1 ein schematisches Blockschaltbild einer ersten Ausgestaltung eines erfindungsgemäßen Filters;

Fig. 2 ein detaillierteres Schaltbild des Filters aus Fig. 1;

Fig. 3 eine zweite Ausgestaltung eines erfindungsgemäßen Filters, das dieselbe Übertragungsfunktion wie das Filter aus Figs. 1 und 2, aber einen einfacheren Aufbau hat;

Fig. 4 eine dritte Ausgestaltung eines erfindungsgemäßen Filters;

Fig. 5 eine vierte Ausgestaltung mit der gleichen Übertragungsfunktion wie das Filter aus Fig. 4 und mit vereinfachter Struktur;

Fig. 6 eine Filteranordnung zur Erzeugung und Filterung quadraturdemodulierter Signale;

Fig. 7 ein erfindungsgemäßes Filter zur gemeinsamen Filterung und Dezimierung von drei Datenfolgen;

Fig. 8 ein Prinzipschaltbild eines Filters zur gemeinsamen Filterung von drei Datenfolgen und Dezimierung der Datenfolgen um den Faktor 6;

Fig. 9 eine konkrete Ausgestaltung des Filters aus Fig. 8;

Fig. 10 einen Multiplexer zum Umsetzen von Datenfolgen in eine durch die Filter aus Fig. 7 oder 8 verarbeitbare Form, und

Fig. 11 ein herkömmliches Filter nach dem Stand der Technik.

Um das Verständnis der Arbeitsweise des erfindungsgemäßen Filters zu erleichtern, wird zunächst anhand von Fig. 11 kurz auf die Arbeitsweise des herkömmlichen Filters eingegangen.

Das herkömmliche Filter umfaßt zwei Äste U und V mit jeweils einem Eingang, der eine ursprüngliche Datenfolge $u_0$, $u_1$, ... bzw. $v_0$, $v_1$, ... empfängt, und einen Umschalter 11, der Ausgabewerte der zwei Äste alternierend an einen Übertragungskanal 13 weitergibt. Die Übertragungskapazität des Kanals 13 entspricht der Taktrate der zwei ursprünglichen Datenfolgen.

Jeder Ast enthält eine Register-Addierer-Kette, die aus einer Mehrzahl von Register-Addierer-Einheiten $1_{X1}$, $1_{X2}$, ... bzw. $1_{Y1}$, $1_{Y2}$, ... besteht, die jeweils ein an einen ersten Eingang der Einheit angeschlossenes Register $3_{X1}$, ... zum Zwischenspeichern von Werten der Datenfolgen oder davon abgeleiteten Werten und einen Addierer $5_{X1}$ ... mit einem an den Ausgang des Registers $3_{X1}$ angeschlossenen Eingang, einem an einen zweiten Eingang der Einheit angeschlossenen Eingang und einem Ausgang, der einen Ausgang der Einheit bildet, umfassen. Beide Eingänge der Einheiten sind jeweils miteinander verbunden. Jede Einheit hat die Übertragungsfunktion $H^*(z^{-1})=z^{-1}+1$, die m-fache Hintereinanderschaltung dieser Einheiten ergibt jeweils Filteräste mit der Übertragungsfunktion $H^*(z^{-1})=(z^{-1}+1)^m$. Beim in Fig. 11 gezeigten Beispiel ist m = 4, die Gesamtübertragungsfunktion jedes Asts ist somit

$$H(z^{-1})=(z^{-1}+1)^4 = 1 + 4z^{-1} + 6z^{-2} + 4z^{-3} + z^{-4}$$

Aus ursprünglichen Datenfolgen $u=[u_1, u_2, u_3, u_4, u_5, u_6]$ bzw. $v=[v_1, v_2, v_3, v_4, v_5, v_6]$ erzeugen die zwei Äste die Folgen

$u_1$
$u_2+4u_1$
$u_3+4u_2+6u_1$
$u_4+4u_3+6u_2+4u_1$
$u_5+4u_4+6u_3+4u_2+u_1$
$u_6+4u_5+6u_4+4u_3+u_2$

bzw.

$v_1$
$v_2+4v_1$
$v_3+4v_2+6v_1$
$v_4+4v_3+6v_2+4v_1$
$v_5+4v_4+6v_3+4v_2+v_1$
$v_6+4v_5+6v_4+4v_3+v_2$.

Diese Werte liegen jeweils zu zweit gleichzeitig an den zwei Eingängen des Umschalters 11 an. Aufgrund der begrenzten Übertragungskapazität des Kanals 13 können nicht alle berechneten Werte übertragen werden. In diesem Fall erfolgt eine Dezimierung der Daten, indem der Umschalter 11 jeweils alternierend während einer Taktperiode der ursprünglichen Datenfolgen den Ast U und dann den Ast V mit dem Übertragungskanal 13 verbindet. Es liegt somit am Eingang des Übertragungskanals 13 je nach Anfangsstellung des Um-schalters 11 die Datenfolge

$$u_1$$
$$v_2+4v_1$$
$$u_3+4u_2+6u_1$$
$$v_4+4v_3+6v_2+4v_1$$
$$u_5+4u_4+6u_3+4u_2+u_1$$
$$v_6+4v_5+6v_4+4v_3+v_2.$$

oder deren Komplement an. Es werden also pro Taktperiode zwei Datenwerte erzeugt, gebraucht werden kann aber nur jeder zweite davon.

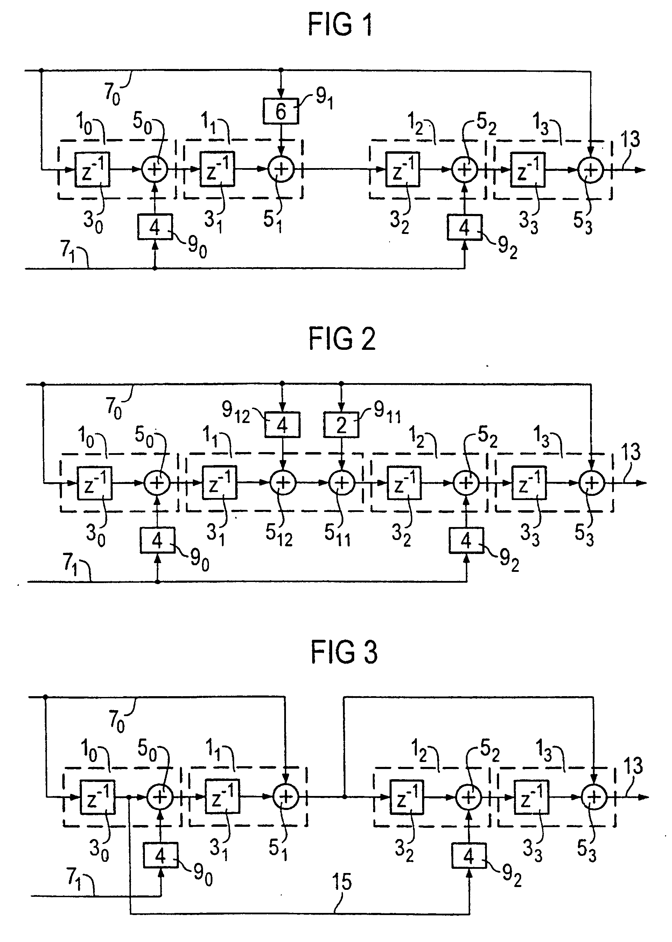

Fig. 1 zeigt eine erste Ausgestaltung eines erfindungsgemäßen Filters. Die Übertragungsfunktion des Filters ist dieselbe wie die des Filters aus Fig. 11. Es umfaßt wie dieses eine Kette mit einer Mehrzahl von Register-Addierer-Einheiten $1_0$, $1_1$, $1_2$, $1_3$ mit jeweils ei-nem Register $3_0$, $3_1$, $3_2$ bzw. $3_3$ und einem Addierer $5_0$, $5_1$, $5_2$ bzw. $5_3$. Diese Einheiten sind in eine nullte Gruppe mit den Einheiten $1_0$ und $1_2$ und eine erste Gruppe mit den Einheiten $1_1$ und $1_3$ unterteilt. Das Register $3_0$ ist mit dem Datenkanal $7_0$ der nullten Gruppe direkt ver-bunden. Der Addierer $5_0$ ist an den Ausgang des Regi-sters $3_0$ und über einen Multiplizierer $9_0$ an den Daten-kanal $9_1$ der ersten Gruppe angeschlossen und gibt somit an das Register der folgenden Einheit $1_1$ die Summe aus dem um einen Takt verzögerten Inhalt des Registers $3_0$ und dem Vierfachen des auf dem Datenkanal $7_1$ an-liegenden Werts aus. Die darauffolgenden Einheiten arbeiten in analoger Weise.

Diesem Filter ist zweckmäßigerweise ein Multiplexer (nicht dargestellt) mit zwei Eingängen vorgeschaltet, wobei jeder Eingang die Werte einer der zwei zu filternden ursprünglichen Datenfolgen u, v empfängt, und das die empfangenen Werte abwechselnd auf den nullten und den ersten Übertragungskanal ausgibt. Diese Maßnahme hat zur Folge, daß in einer Taktperiode, in der z. B. auf dem ersten Datenkanal $9_1$ ein Wert der ersten Folge u anliegt, die Register $3_0$ und $3_2$ Datenwer-te an die Addierer $5_0$, $5_2$ ausgeben, die von Werten der Folge u abgeleitet sind, und umgekehrt. In der nächsten Taktperiode sind die von der Folge u abgeleiteten Werte in die Register der nullten Gruppe übergegangen. Da in dieser Taktperiode der Wert der ursprünglichen Folge u vom Multiplexer auf den anderen Datenkanal $7_0$ ausge-geben wird, werden auch diesmal nicht Werte der verschiedenen Folgen vermengt.

Es ist offensichtlich, daß alle Übertragungs-funktionen der Form

$$H(z) = a_0 + a_1 z^{-1} + a_2 z^{-2} + ...$$

mit dem erfindungsgemäßen Filter realisiert werden können, indem je nach Bedarf die Zahl der Einheiten und die Multiplikationsfaktoren entsprechend gewählt werden.

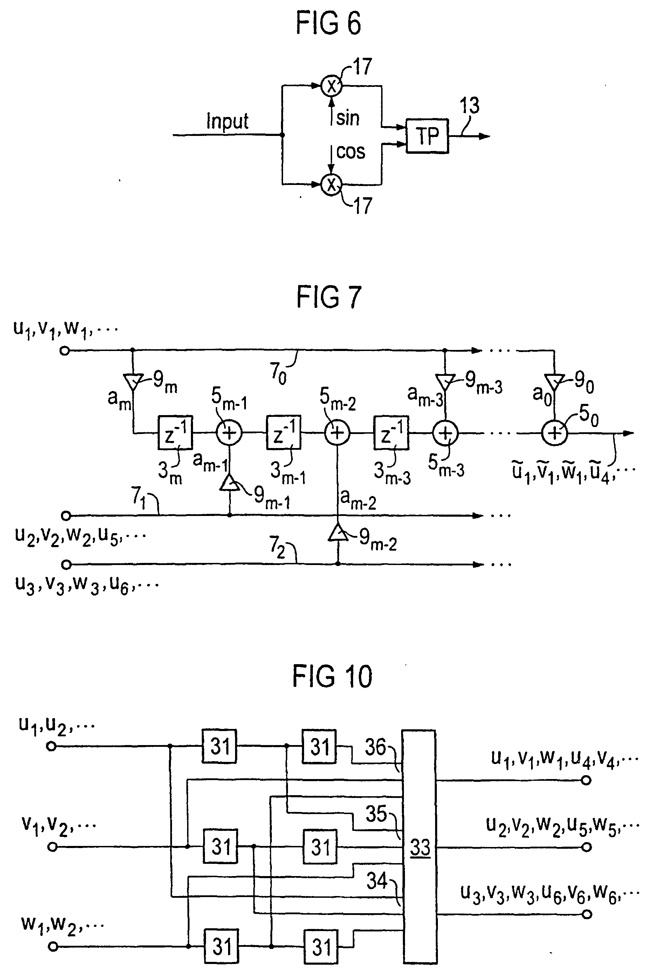

Zur Erweiterung der Schaltung zur Verarbeitung einer zusätzlichen ursprünglichen Datenfolge genügt es, die Zahl der Gruppen um 1 zu erhöhen, die vorhandenen Register-Addierer-Einheiten zyklisch auf die Gruppen zu verteilen und einen weiteren Datenkanal vorzusehen, an den die Einheiten der neugeschaffenen Gruppe angeschlossen werden, wie später anhand von Fig. 7 - 9 am Beispiel von drei Datenfolgen u, v, w gezeigt

Fig. 2 zeigt eine Variante der Schaltung aus Fig. 1, bei der die Multiplizierer einen besonders einfachen Aufbau haben. Bei dieser Variante wird die Tatsache ausgenutzt, daß sich bei binärer Zahlendarstellung Multiplikationen mit einer Zweierpotenz $2^j$ sehr einfach realisieren lassen, indem an die zu multiplizierende Zahl rechts j Nullen angehängt werden. Der Multiplizierer $9_0$ kann daher schlicht und einfach dadurch realisiert werden, daß sämtliche Bits 0, 1, ...,ν des Übertragungska-nals $7_1$ mit Eingangsbits j, j+1, ..., j+ν eines Eingangs des Addierers 50 verbunden sind. Die Eingangsbits 0, ..., j-1 desselben Eingangs des Addierers können fest auf den Wert 0 gelegt sein. Eine besonders einfache Ausgestaltung des Addierers ergibt sich dann, wenn dieser nur Eingänge für die Bits mit Stellenwert $2^j$ oder darüber aufweist. Da sich die Inhalte niedrigerwertiger Leitungen bei der Addition nicht ändern können, brauchen sie vom Addierer nicht erfaßt zu werden. Diese niedrigwertigen Leitungen können deshalb direkt vom Ausgang des zur Einheit des Addierers gehörenden Registers zum Eingang des Registers der nachfolgenden Einheit durchgeführt sein.

Im Falle des Multiplizierers $9_0$ sind für eine Multiplikation mit dem Faktor 4 die Ausgangsleitungen des Multiplizierers um 2 Bit gegenüber den Eingangsleitungen nach links verschoben.

Der Multiplizierer $9_1$ zum Multiplizieren mit dem Faktor 6 kann nicht ganz so einfach realisiert werden. Er besteht aus zwei Submultiplizierern $9_{11}$ und $9_{12}$, wobei der Submultiplizierer $9_{12}$ genauso wie der Multi-plizierer $9_0$ aufgebaut ist und der Submultiplizierer durch Verschieben um ein Bit nach links eine Multiplikation mit 2 durchführt. Entsprechend umfaßt der Addierer $5_1$ zwei Subaddierer $5_{11}$, $5_{12}$, die die Ausgabewerte der Submultiplizierer zum Ausgabewert des Registers $3_1$ hinzu-addieren.

Fig. 3 zeigt eine Weiterentwicklung des Filters aus Fig. 1 bzw. 2, bei dem die Multiplikation mit Faktoren, die keine Zweierpotenzen sind, völlig vermieden ist. Diese Ausgestaltung basiert auf der Erkenntnis, daß der zweite Eingang der Register-Addierer-Einheiten nicht zwangsläufig an den der jeweiligen Gruppe entsprechenden Datenkanal angeschlossen sein muß, sondern daß er auch mit dem Ausgang einer derselben Gruppe angehörenden Einheit verbunden sein darf, ohne daß dies zu einer unerwünschten Vermengung der Daten der verschiedenen Folgen U und V führt, und daß sich mit Hilfe solcher Verbindungen die Schaltungsstruktur vereinfachen läßt.

Wie die Filter aus Fig. 1 und 2 hat das in Fig. 3 gezeigte Filter vier hintereinandergeschaltete Register-Addierer-Einheiten $1_0$, $1_1$, $1_2$, $1_3$. Das Ausgangssignal des Registers $3_0$ ist über eine Leitung 15 abgegriffen und auf den zweiten Eingang der dritten Einheit $1_2$ geführt. Der Ausgang der Einheit $1_1$ ist mit dem zweiten Eingang der Einheit $1_3$ verbunden. Wie man leicht erkennt, haben die ersten zwei Einheiten $1_0$, $1_1$ der Schaltung zusammen mit dem Multiplizierer $9_0$ die Übertragungsfunktion $H^*_1(z^{-1}) = z^{-2}+4z^{-1}+1$. Durch Verzögern im Register $3_2$ und Hinzuaddieren des Vierfachen des über die Leitung 15 übertragenen Signals $z^{-1}$ mit Hilfe des Multiplizierers $9_2$ und des Addierers $5_2$ ergibt sich für den Ausgang der Einheit $1_2$ die Übertragungsfunktion

$$H^*_2(z^{-1}) = (z^{-2}+4z^{-1}+1)z^{-1} +4z^{-1} = z^{-3}+4z^{-2}+5z^{-1} .$$

Erneutes Verzögern im Register $3_3$ und Hinzuaddieren von $H^*_1(z^{-1})$ im Addierer $5_3$ liefert die gewünschte Übertragungsfunktion. Hierfür kommt die Schaltung nach Fig. 3 mit minimalem Aufwand aus: Es werden lediglich vier Register und vier Addierer -verwendet, und die Multiplizierer haben, soweit noch erforderlich, den denkbar einfachsten Aufbau, da sie lediglich zur Multiplikation mit Zweierpotenzen benötigt werden.

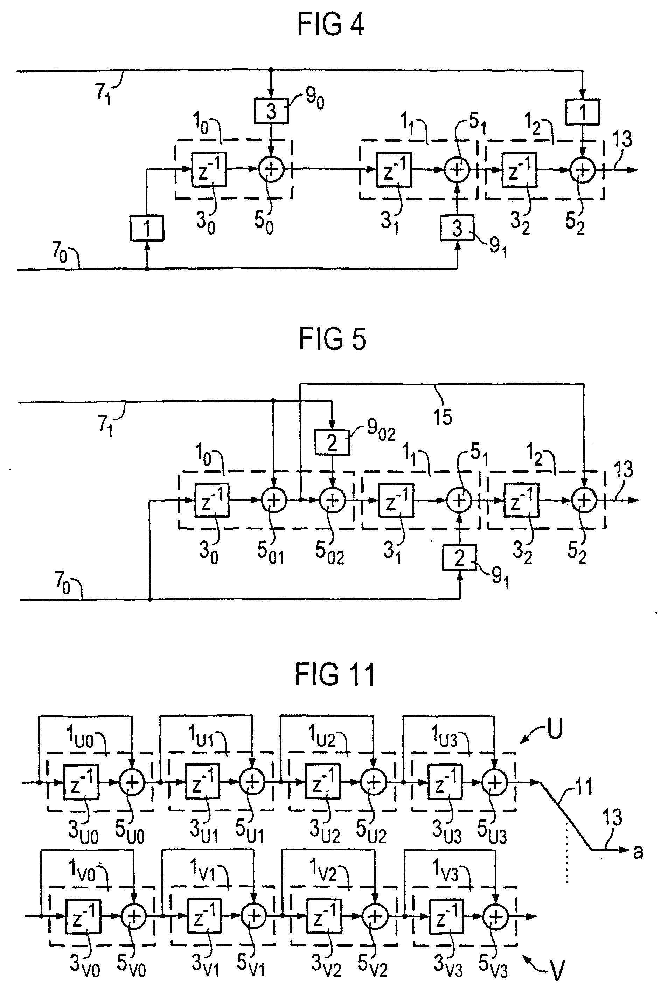

Die Figs. 4 und 5 zeigen zwei erfindungsgemäße Filter für die Übertragungsfunktion

$$H(z^{-1})=(z^{-1} +1)^3 = 1 + 3z^{-1} + 3z^{-2} + z^{-3} .$$

Das Filter aus Fig. 4 ist nach demselben Prinzip konstruiert wie das aus Fig. 1. Die zweiten Eingänge der drei Register-Addierer-Einheiten sind jeweils über Multiplizierer mit einem der Datenkanäle $7_0$ bzw. $7_1$ verbunden, wobei die Faktoren der Multiplizierer gleich den entsprechenden Koeffizienten der als Polynom geschriebenen Übertragungsfunktion sind.

Die Multiplizierer können nach dem in Fig. 2 gezeigten Prinzip aus Submultiplizierern aufgebaut sein.

Fig. 5 zeigt wiederum ein Filter mit vereinfachtem Aufbau. Der Multiplizierer $9_0$ ist durch einen verdoppelnden Submultiplizierer $9_{02}$ und eine direkte Verbindung mit dem Datenkanal $7_0$ sowie zwei Addierer $5_{01}$, $5_{02}$ implementiert. Über eine Leitung 15 wird ein Signal mit der Übertragungsfunktion $H^*_0(z^{-1}) = z^{-1}+1$ abgegriffen und auf den zweiten Eingang der Einheit $1_2$ geführt. Diese Abwandlung gestattet es, anstelle des in Fig. 4 verwendeten Verdreifachers einen Verdoppler $9_2$ zu verwenden, weswegen das Filter aus Fig. 5 zur Realisierung derselben Übertragungsfunktion mit einem Addierer weniger auskommt.

Fig. 6 zeigt das Prinzipschaltbild eines Filters mit Quadraturdemodulation einer Eingangsfolge. Üblicherweise werden bei solch einem Filter mit einer Sinus- und einer Cosinusschwingung modulierte Datenfolgen aus einer ursprünglichen Datenfolge erzeugt, indem in zwei Multiplizierern 17 die ursprünglichen Werte mit Sinus- und Cosinuswerten multipliziert werden, die z. B. aus einem ROM ausgelesen werden. Erfindungsgemäß multipliziert jeder der Multiplizierer 17 die eintreffenden ursprünglichen Datenwerte alternierend mit einem Sinusund einem Cosinuswert. Dies hat zur Folge, daß Werte, die der sinus- (bzw. cosinus-)modulierten Folge angehören, abwechselnd an den Datenkanälen $7_0$ bzw. $7_1$ anliegen, ohne daß hierfür ein vorgeschalteter Multiplexer erforderlich ist.

Fig. 7 zeigt die Anwendung des erfindungsgemäßen Konstruktionsprinzips auf ein Filter zur gemeinsamen Filterung von drei Datenfolgen. Dieses Filter kann insbesondere zur Filterung und Dezimierung von digitalisierten RGB- oder YUV-Daten in der Fernseh- und Videotechnik eingesetzt werden.

Dem Filter ist ein der in Fig. 10 gezeigte Multiplexer vorgeschaltet, der auf drei Eingängen die drei Datenfolgen $u=[u_1, u_2, u_3, u_4, u_5, u_6,...]$, $v=[v_1, v_2, v_3, v_4, v_5, v_6, ...]$ und $w=[w_1, w_2, w_3, w_4, w_5, w_6, ...]$ empfängt. Jedem Eingang sind zwei Register 31 zugeordnet, die jeden eintreffenden Folgenwert abspeichern und um eine Taktperiode verzögern. Ein Steuerschalter 33 hat drei Gruppen 34-36 mit je drei Eingängen. Jede Gruppe enthält einen direkt mit dem Eingang des Multiplexers verbundenen, einen einfach verzögerten und einen doppelt verzögerten Eingang. Zu Beginn der Umsetzung liegen am Eingang des Multiplexers die Folgenwerte $u_1$, $v_1$, $w_1$ an, und die Register enthalten Nullen. Die Steuerschaltung 33 schaltet die an ihrem Eingang 34 anliegenden Werte $u_1$, 0, 0 auf den Ausgang durch. Im nachfolgenden Takt liegen Werte $u_2$, $v_2$, $w_2$ am Eingang des Multiplexers. Die einfach verzögernden Register enthalten die Werte $u_1$, $v_1$, $w_1$, die zweifach verzögernden enthalten Nullen. Die am Eingang 35 anliegenden Werte $u_1$, $v_2$, 0 werden ausgegeben. Im Folgetakt gibt die Schaltung die am Eingang 36 anliegenden Werte $w_1$, $v_2$, $u_3$ aus. Die drei Kanäle $7_0$, $7_1$, $7_2$ des Filters werden so mit Datenfolgen $u_1$, $v_1$, $w_1$, $u_4$, $v_4$, $w_4$, ...; 0, $u_2$, $v_2$, $w_2$, $u_5$, $v_5$, $w_5$, ... bzw. 0, 0, $u_3$, $v_3$, $w_3$, $u_6$, $v_6$, ... versorgt.

Das Konstruktionsprinzip des Multiplexers aus Fig. 10 läßt sich für beliebige Zahlen n gemeinsam zu verarbeitender Datenfolgen anwenden. Dabei ist jedem der n Eingänge des Multiplexers eine Kette von n-1 Registern zugeordnet, und der Steuerschalter hat n Gruppen zu n Eingängen, von denen jeweils einer mit einem Eingang der Schaltung bzw. dem Ausgang eines i-fach verzögernden Registers verbunden ist (i=1, 2, ..., n-1).

Das Filter in Fig. 7 enthält wie das aus Fig. 1 eine Kette, die abwechselnd aus Addierern $5_{m-1}$, $5_{m-2}$, ... 50 und Registern $3_m$, ..., $3_0$ aufgebaut ist. Jedem der drei Datenkanäle $7_0$, $7_1$, $7_2$, des Filters ist eine Gruppe von Registern $3_m$, $3_{m-3}$, ...; $3_{m-1}$, ... bzw. $3_{m-2}$, ... zugeordnet, die über Multiplizierer $9_m$, $9_{m-1}$, ...

und ggf. Addierer $5_{m-1}$, $5_{m-2}$, ... mit ihrem Datenkanal verbunden sind, um eine Übertragungsfunktion der Form

$$H(z) = a_m z^m + a_{m-1} z^{m-1} + ... + a_0$$

zu realisieren. In einem ersten Arbeitstakt empfängt das Filter auf den drei Datenkanälen das Wertetripel u1, 0, 0. Die dem Kanal $7_0$ zugeordneten Register 3m, $3_{m-3}$, ... empfangen Werte $a_m u_1$, $a_{m-3} u_1$, ... usw., die Register der anderen Gruppen bleiben noch unbelegt. In einem zweiten Takt liegen auf den drei Kanälen die Werte $v_1$, $u_2$, 0. Die Addierer $5_{m-1}$, $5_{m-4}$ addieren zu den Inhalten der Register $3_m$, $3_{m-3}$, ... jeweils Werte $a_{m-1} u_2$, $a_{m-4} u_2$, ... und geben sie in der Kette eine Stelle weiter in die Register $3_{m-1}$, $5_{m-4}$, .... Gleichzeitig werden Werte $a_m v_1$, $a_{m-3} v_1$, ... usw. in die Register der dem Kanal $7_0$ zugeordneten Gruppe geladen. Im nächsten Takt wandern die Werte wiederum einen Schritt weiter, und die dem Kanal $7_0$ zugeordneten Register werden mit $a_m w_1$, $a_{m-3} w_1$, ... usw. geladen. Nach m Takten beginnt das Filter, eine Datenfolge der Form

$$a_m u_1 + a_{m-1} u_2 + ... + a_0 u_m;$$

$$a_m v_1 + a_{m-1} v_2 + ... + a_0 v_m;$$

$$a_m w_1 + a_{m-1} w_2 + ... + a_0 w_m;$$

$$a_m u_4 + a_{m-1} u_5 + ... + a_0 u_{m+3};$$

$$...$$

auszugeben. Die Filterung der Folgen u, v und w beinhaltet gleichzeitig eine Dezimierung um den Faktor 3.

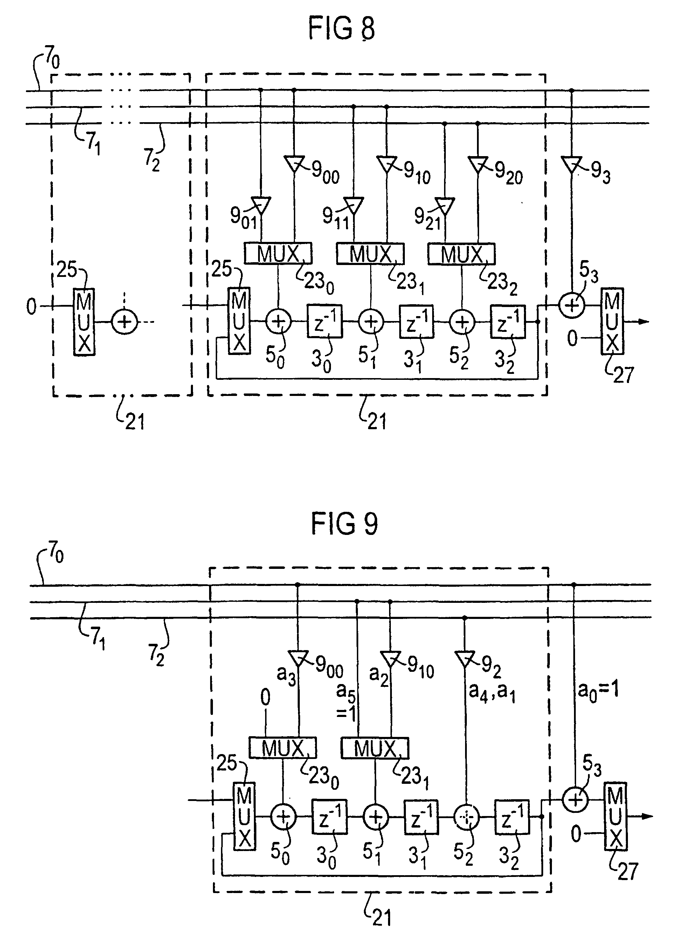

Fig. 8 zeigt das Prinzip eines Filters zum gemeinsamen Filtern und Dezimieren um den Faktor 6. Das Filter umfaßt drei Datenkanäle $7_0$, $7_1$, $7_2$ zum Empfangen der vom Multiplexer aus Fig. 10 ausgegebenen Datenfolgen. Je nach Stufe des Polynoms der Übertragungsfunktion H(z) besitzt das Filter eine oder mehrere hintereinandergeschaltete Filterstufen 21, die jeweils entsprechend der Zahl der Datenkanäle eine Kette aus je drei Addierern $5_0$, $5_1$, $5_2$, und drei Register $3_0$, $3_1$, $3_2$ sowie drei erste Multiplexer $23_0$, $23_1$, $23_2$ und zweimal drei Multiplizierer $9_{00}$, $9_{10}$, $9_{20}$ und $9_{01}$, $9_{11}$, $9_{21}$ umfassen. Jeder erste Multiplexer $23_i$ (i=0, 1, 2) hat zwei Eingänge, die über die Multiplizierer $9_{i0}$, $9_{i1}$ mit dem Datenkanal $7_i$ verbunden sind. Bei einer tatsächlichen Implementierung des Filters aus Fig. 8 können je nach Übertragungsfunktion einzelne Multiplizierer und Multiplexer entfallen, wie später erläutert wird.

Der Eingang des ersten Addierers 50 der Kette ist mit einem zweiten Multiplexer 25 verbunden, von dem ein Eingang den Eingang der Stufe 21 bildet und dessen zweiter Eingang mit dem Ausgang des letzten Registers $3_2$ verbunden ist. Der Ausgang des letzten Registers $3_2$ ist gleichzeitig Ausgang der Filterstufe 21. Der Ausgang jeder Filterstufe 21 mit Ausnahme der letzten führt auf den Eingang einer nachfolgenden Filterstufe. Der Ausgang der letzten führt zu einem Addierer $5_3$, dessen zweiter Eingang über einen Multiplizierer $9_3$ an den Kanal $7_0$ angeschlossen ist, zu einem Multiplexer 27, der das Ergebnis der Filterung und Dezimierung ausgibt.

Die Arbeitsweise des Filters wird anhand des Ausführungsbeispiels in Fig. 9 erläutert. Dieses Filter ist angelegt für eine Übertragungsfunktion

$$H(z^{-1}) = \Sigma a_j z^{-j} = z^{-5} + 5z^{-4} + 10z^{-3} + 10z^{-2} + 5z^{-1} + 1.$$

Es besitzt nur eine Filterstufe 21. Der dem Koeffizienten $a_0 = 1$ entsprechende Multiplizierer $9_3$ ist entfallen, genauso der $a_5 = 1$ entsprechende Multiplizierer $9_{11}$. Da $a_6 = 0$, ist der entsprechende Multiplizierer $9_{01}$ durch einen Nullsignal-Eingang ersetzt. Da die Faktoren $a_4$ und $a_1$ gleich sind, ist für sie nur ein Multiplizierer $9_2$ vorgesehen und der Multiplexer ist $23_2$ entfallen.

Das Filter empfängt die Datenfolgen $v_1$, $w_1$, $u_4$, $v_4$, $w_4$, ...; $u_2$, $v_2$, $w_2$, $u_5$, $v_5$, $w_5$, ... bzw. 0, $u_3$, $v_3$, $w_3$, $u_6$, $v_6$, ... vom Multiplexer aus Fig. 10. Zu Beginn des Betriebs sind die Multiplexer so gesteuert, daß die ersten Multiplexer ihre in der Fig. links dargestellten Eingänge selektieren und der zweite Multiplexer 25 den oberen Eingang selektiert, an dem ständig 0 anliegt. Vom ersten auf den Kanälen erscheinenden Wertetripel $v_1$, $u_2$, 0 geht der Wert $v_1$ verloren, die Register $3_0$, $3_1$, $3_2$ bekommen die Inhalte 0, $5u_2$, 0. Der nächste Takt mit dem Wertetripel $w_1$, $v_2$, $u_3$ führt zu Registerinhalten 0, $5v_2$, $5u_2 + 10u_3$. Zum darauffolgenden Takt werden die Multiplexer $23_0$, und 25 umgeschaltet, so daß die vom Register $3_2$ ausgegebenen Werte auf den Addierer 50 zurückgeführt werden und der rechte Eingang des ersten Multiplexers $23_0$ aktiv ist. Das Wertetripel $u_4$, $w_2$, $v_3$ ergibt somit die Registerbelegung $5u_2 + 10u_3 + 10u_4$, $5v_2 + 10v_3$, $5w_2$. Mit dem nächsten Takt müßte, wenn er vorhanden wäre, der Multiplexer $23_1$ umgeschaltet werden, danach der Multiplexer $23_2$. Noch einen Takt später selektiert der Multiplexer 27 seinen oberen Eingang und gibt drei Takte lang die Filterungsergebnisse für die Folgen u, v, w aus. Im Dauerbetrieb des Filters wechseln sämtliche Multiplexer nach jeweils drei Takten ihren Zustand. Man erhält so für je sechs eingegebene Folgenwerte einen gefilterten Wert, also einen Dezimationsfaktor von 6.

Höhere Dezimationsfaktoren, die immer ein ganzzahliges Vielfaches der Kanalzahl sind, lassen sich auf einfache Weise erzielen, wenn man die Anzahl der Eingänge der ersten Multiplexer und die Zahl der Male, die die eingegebenen Daten in der Filterstufe im Kreis laufen, erhöht.

Dieselbe Wirkung wie mit den Filtern aus Fig. 7-9 läßt sich erzielen, wenn man die eingangsseitigen zweiten Multiplexer 25 durch Demultiplexer am Ausgang des letzten Registers $5_2$ ersetzt.

Auch die Multiplizierer der Filter aus Fig. 7 bis 9 können aus Submultiplizierern wie in Verbindung mit Fig. 2 beschrieben aufgebaut werden. Im Falle des Filters aus Fig. 8 bzw. 9 können insbesondere an denselben Multiplexer angeschlossene Multiplizierer Submultiplizierer gemeinsam haben.

**Patentansprüche**

1. Filter zur Filterung von n Datenfolgen im Zeitmultiplex, wobei n eine ganze Zahl > 1 ist, mit einer Mehrzahl von Registern ($3_0$, $3_1$, $3_2$, $3_3$) zum Zwischenspeichern von Werten der Datenfolgen oder davon abgeleiteten Werten und Addierern ($5_0$, $5_1$, $5_2$, $5_3$), wobei die Register und die Addierer abwechselnd miteinander zu einer Kette verbunden sind, **dadurch gekennzeichnet, daß** die Register in n Gruppen ($3_0$, $3_2$; $3_1$, $3_3$) unterteilt sind, jeder Gruppe ein Datenkanal ($7_0$, $7_1$) zum Empfangen von Werten der Datenfolgen zugeordnet ist, wobei der erste Eingang jedes einem Register ($3_0$, $3_2$; $3_1$, $3_3$) der i-ten Gruppe ($0 \leq i \leq n-1$) vorgeschalteten Addierers ($5_0$, $5_2$; $5_1$, $5_3$) eine Verbindung mit dem der i-ten Gruppe zugeordneten Datenkanal ($7_i$) und der zweite Eingang desselben Addierers eine Verbindung mit einem Register ($3_1$, $3_3$; $3_0$, $3_2$) der Gruppe mit der Nummer (i-1)mod n ohne zwischengeschaltetes Register einer weiteren Gruppe hat,

2. Filter nach Anspruch 1, **dadurch gekennzeichnet, daß** wenigstens eine der Verbindungen einen Multiplizierer ($9_0$, $9_1$, $9_2$) umfaßt.

3. Filter nach Anspruch 1 oder 2, **dadurch gekennzeichnet, daß** wenigstens eine der Verbindungen eine Mehrzahl von parallelen Multiplizierern zum Multiplizieren mit verschiedenen Faktoren und einen Schalter zum selektiven Verbinden eines der Multiplizierer mit dem zugeordneten Addierer ($5_0$, $5_1$, $5_2$, $5_3$) umfaßt.

4. Filter nach einem der vorhergehenden Ansprüche, **dadurch gekennzeichnet, daß** er wenigstens einen Multiplizierer ($9_0$, $9_1$) zum Multiplizieren mit einem Faktor k, der keine Zweierpotenz ist, enthält, wobei der Multiplizierer ($9_0$; $9_1$) aus einer Mehrzahl paralleler Submultiplizierer ($9_{01}$, $9_{02}$; $9_{11}$, $9_{12}$) zum Multiplizieren mit je einer Zweierpotenz $2^j$ und Addierern ($5_{01}$, $5_{02}$) aufgebaut ist, die die Ausgabewerte der Submultiplizierer addieren, und wobei die Submultiplizierer eine Verbindung ihrer Eingangsdatenleitungen mit um jeweils um j Bits nach links verschobenen Ausgangsleitungen umfassen.

5. Filter nach einem der vorstehenden Ansprüche, **dadurch gekennzeichnet, daß** zum Realisieren einer als Polynom in $z^{-1}$ darstellbaren Übertragungsfunktion $H(z^{-1}) = \Sigma a_j z^{-j}$, wobei j=0, 1, ..., m-1 ist, die Kette m Addierer ($5_0$, $5_1$, $5_2$, $5_3$) und Register ($3_0$, $3_1$, $3_2$, $3_3$) umfaßt, wobei der Eingang des nullten Registers ($3_0$) mit dem zugeordneten Datenkanal ($7_0$, $7_1$) und für alle j>0 der Eingang des j-ten Registers ($3_1$, $3_2$, $3_3$) mit dem Ausgang des (j-1)-ten Addierers ($5_0$, $5_1$, $5_2$) verbunden ist.

6. Filter nach Anspruch 5, **dadurch gekennzeichnet, daß** für alle $a_j \neq 1$ ein Eingang des j-ten Addierers ($5_0$, $5_1$, $5_2$, $5_3$) mit dem zugehörigen Datenkanal ($7_0$, $7_1$) über einen Multiplizierer ($9_0$, $9_1$, $9_2$) zum Multiplizieren mit dem Faktor $a_j$ verbunden ist.

7. Filter nach einem der Ansprüche 1 bis 5, **dadurch gekennzeichnet, daß** wenigstens ein Addierer zwei Eingänge aufweist, die mit den Ausgängen von zwei derselben Gruppe angehörenden Registern verbunden sind.

8. Filter nach einem der vorhergehenden Ansprüche, **gekennzeichnet durch** einen Schalter, der den Ausgang eines Registers der Gruppe (i+1)mod n ($0 \leq i \leq n-1$) wahlweise mit den Eingängen verschiedener, Register der Gruppe i vorgeschalteter Addierer verbindet.

9. Filter nach einem der vorhergehenden Ansprüche, **gekennzeichnet durch** einen Schalter, der den Eingang eines einem Register der Gruppe (i+1)mod n ($0 \leq i \leq n-1$) vorgeschalteten Addierers wahlweise mit den Ausgängen verschiedener Register der Gruppe i verbindet.

10. Filter nach einem der vorstehenden Ansprüche, **gekennzeichnet durch** einen Multiplexer (Fig. 10) mit n Eingängen für die n Datenfolgen (u, v, w) und n Ausgängen, an die jeweils einer der n Datenkanäle ($7_0$, $7_1$) angeschlossen ist, wobei der Multiplexer eingerichtet ist, Datenwerte einer der Datenfolgen im zyklischen Wechsel auf die verschiedenen Datenkanäle ($7_0$, $7_1$) auszugeben.

11. Filter nach einem der vorhergehenden Ansprüche, **gekennzeichnet durch** einen Demultiplexer, der an den Ausgang einer der Addierer angeschlossen ist, mit n Ausgängen, die jeweils einen einer der Datenfolgen zugeordneten Ausgang des Filters bilden.

12. Filteranordnung zum Erzeugen von zwei quadraturdemodulierten Datenfolgen aus einer gemeinsamen Ursprungsfolge und zum Filtern der erzeugten Folgen,

**gekennzeichnet durch** einen Filter nach einem der Ansprüche 1 bis 10, wobei n=2 ist, zwei Multiplizierer (17), die die Werte der Ursprungsfolge empfangen, wobei die Multiplizierer (17) eingerichtet sind, empfangene Werte alternierend mit Sinus- und Cosinus-Faktoren zu multiplizieren und auf die Datenkanäle $(7_0, 7_1)$ auszugeben.

13. Verfahren zum Betreiben eines Filters nach einem der Ansprüche 1 bis 12, mit den Schritten:

   a) für alle i=0, ..., n-1: Anlegen eines Wertes der i-ten Datenfolge an den Datenkanal $(7_0, 7_1)$ der Gruppe (i+d)mod n;
   b) Abspeichern der an den ersten Eingängen aller Register $(3_0, 3_1, 3_2, 3_3)$ anliegenden Werte in den Registern $(3_0, 3_1, 3_2, 3_3)$;
   c) Verändern von d um 1; und
   d) Wiederholen der Schritte a) bis c) so oft wie erforderlich.

14. Verfahren nach Anspruch 13, wobei die Taktraten aller Datenfolgen dieselben sind.

15. Verfahren nach Anspruch 14, wobei die Schritte a) bis c) in jeder Taktperiode der Datenfolgen n-mal durchgeführt werden.

16. Verfahren nach Anspruch 14, wobei die Schritte a) bis c) in jeder Taktperiode der Datenfolgen einmal durchgeführt werden.

17. Verwendung eines Filters nach einem der Ansprüche 1 bis 12 zur parallelen Dezimierung von n Datenfolgen um einen gemeinsamen Faktor.

**Claims**

1. A filter for filtering n data sequences in time multiplex, wherein n is a whole number > 1, having a plurality of registers $(3_0, 3_1, 3_2, 3_3)$ for buffering values of the data sequences or values derived therefrom and adders $(5_0, 5_1, 5_2, 5_3)$, with the registers and the adders being alternately connected to one another to form a chain,
   **characterised in that** the registers are divided into n groups $(3_0, 3_2; 3_1, 3_3)$, a data channel $(7_0, 7_1)$ for receiving values of the data sequences is assigned to each group, with the first input of each adder $(5_0, 5_2; 5_1, 5_3)$ connected in front of a register $(3_0, 3_2; 3_1, 3_3)$ of the $i^{th}$ group (0≤i≤n-1) having a connection with the data channel $(7_i)$ assigned to the $i^{th}$ group and the second input of the same adder having a connection with a register $(3_1, 3_3; 3_0, 3_2)$ of the group with the number (i-1)mod n without a register of another group connected between them.

2. A filter according to Claim 1,
   **characterised in that** at least one of the connections comprises a multiplier $(9_0, 9_1, 9_2)$.

3. A filter according to Claim 1 or 2,
   **characterised in that** at least one of the connections comprises a plurality of parallel multipliers for multiplication with various factors and a switch for selectively connecting one of the multipliers to the associated adder $(5_0, 5_1, 5_2, 5_3)$.

4. A filter according to one of the preceding Claims,
   **characterised in that** it contains at least one multiplier $(9_0, 9_1)$ for multiplication with a factor k, which is not a power of two, with the multiplier $(9_0, 9_1)$ being formed from a plurality of parallel sub-multipliers $(9_{01}, 9_{02} ; 9_{11}, 9_{12})$ for multiplication each with a power of two $2^j$ and adders $(5_{01}, 5_{02})$, which add the output values of the submultipliers, and with the submultipliers comprising a connection of their input data lines with output lines shifted by j bits to the left in each case.

5. A filter according to one of the preceding Claims,
   **characterised in that** for implementing a transfer function, which can be represented as a polynomial in $z^{-1}$, $H(z^{-1})=\Sigma a_j z^{-j}$, in which j=0, 1, ..., m-1, the chain comprises m adders $(5_0, 5_1, 5_2, 5_3)$ and registers $(3_0, 3_1, 3_2, 3_3)$, with the input of the zero register $(3_0)$ being connected to the associated data channel $(7_0, 7_1)$ and for all j>0 the input of the $j^{th}$ register $(3_1, 3_2, 3_3)$ being connected to the output of the $(j-1)^{th}$ adder $(5_0, 5_1, 5_2)$.

6. A filter according to Claim 5,
   **characterised in that** for all aj≠1 an input of the $j^{th}$ adder $(5_0, 5_1, 5_2, 5_3)$ is connected to the associated data channel $(7_0, 7_1)$ via a multiplier $(9_0, 9_1, 9_2)$ for multiplication with the factor $a_j$.

7. A filter according to one of Claims 1 to 5,
   **characterised in that** at least one adder comprises two inputs, which are connected to the outputs of two registers belonging to the same group.

8. A filter according to one of the preceding Claims,
   **characterised by** a switch which connects the output of one register of the group (i+1)mod n (0≤i≤n-1) optionally with the inputs of various adders which are connected in front of registers of group i.

9. A filter according to one of the preceding Claims,
   **characterised by** a switch which connects the input of an adder connected in front of a register of the group (i+1)mod n (0≤i≤n-1) optionally with the outputs of various registers of group i.

**10.** A filter according to one of the preceding Claims, **characterised by** a multiplexer (Figure 10) having n inputs for the n data sequences (u, v, w) and n outputs, to which in each case one of the n data channels ($7_0$, $7_1$) is connected, with the multiplexer being equipped to output data values of one of the data sequences in cyclic change to the various data channels ($7_0$, $7_1$).

**11.** A filter according to one of the preceding Claims, **characterised by** a demultiplexer, which is connected to the output of one of the adders, having n outputs, which in each case form an output of the filter associated with one of the data sequences.

**12.** A filter arrangement for producing two quadrature-demodulated data sequences from a common original sequence and for filtering the sequences produced, **characterised by** a filter according to one of Claims 1 to 10, in which n=2, two multipliers (17), which receive the values of the original sequence, wherein the multipliers (17) are equipped to multiply received values alternately with sine and cosine factors and to output them to the data channels ($7_0$, $7_1$).

**13.** A method for the operation of a filter according to one of Claims 1 to 12, having the following steps:

a) for all i=0, ..., n-1: applying a value of the $i^{th}$ data sequence to the data channel ($7_0$, $7_1$) of the group (i+d)mod n;
b) storing the values present at the first inputs of all registers ($3_0$, $3_1$, $3_2$, $3_3$ ) in the registers ($3_0$, $3_1$, $3_2$, $3_3$);
c) changing d by 1; and
d) repetition of steps a) to c) as often as required.

**14.** A method according to Claim 13, in which all the clock pulse rates of all data sequences are the same.

**15.** A method according to Claim 14, in which the steps a) to c) are carried out n times in each clock pulse period of the data sequences.

**16.** A method according to Claim 14, in which the steps a) to c) are carried out once in each clock pulse period of the data sequences.

**17.** Use of a filter according to one of Claims 1 to 12 for the parallel decimation of n data sequences by a common factor.

## Revendications

**1.** Filtre pour filtrer (n) suites de données en multiplexage dans le temps, n étant un nombre entier > 1, comprenant plusieurs registres ($3_0$, $3_1$, $3_2$, $3_3$) pour enregistrer de façon intermédiaire des valeurs des suites de données ou des valeurs déduites de celles-ci et des additionneurs ($5_0$, $5_1$, $5_2$, $5_3$), les registres et les additionneurs étant reliés alternativement les uns aux autres pour former une chaîne, **caractérisé en ce que** les registres sont subdivisés en n groupes ($3_0$, $3_2$ ; $3_1$, $3_3$), chaque groupe comprend un canal de données ($7_0$, $7_1$) pour recevoir des valeurs des suites de données, la première entrée des additionneurs en amont ($5_0$, $5_2$ ; $5_1$, $5_3$) de chaque registre ($3_0$, $3_2$ ; $3_1$, $3_3$) du groupe d'ordre i (0≤i≤n-1) ayant une liaison avec le canal de données ($7_i$) associé au groupe numéro i et la seconde entrée du même additionneur est reliée à un registre ($3_1$, $3_3$ ; $3_0$, $3_2$) du groupe de numéro (i-1) modulo n, sans registre intermédiaire d'un autre groupe.

**2.** Filtre selon la revendication 1, **caractérisé en ce qu'** au moins l'une des liaisons comprend un multiplicateur ($9_0$, $9_1$, $9_2$).

**3.** Filtre selon l'une quelconque des revendications 1 ou 2, **caractérisé en ce qu'** au moins l'une des liaisons comprend plusieurs multiplicateurs en parallèle pour multiplier par différents coefficients et un commutateur pour relier sélectivement l'un des multiplicateurs à l'additionneur associé ($5_0$, $5_1$, $5_2$, $5_3$).

**4.** Filtre selon l'une quelconque des revendications précédentes, **caractérisé en ce qu'**il comporte au moins un multiplicateur ($9_0$, $9_1$) pour multiplier avec un coefficient k qui ne correspond pas à une puissance de deux, le multiplicateur ($9_0$, $9_1$) étant formé de plusieurs sous multiplicateurs ($9_{01}$, $9_{02}$ ; $9_{11}$, $9_{12}$) pour multiplier chaque fois avec une puissance de deux $2^j$ et des additionneurs ($5_{01}$, $5_{02}$) qui additionnent les valeurs émises par les sous multiplicateurs, et les sous multiplicateurs ont leur ligne de données d'entrée reliée avec des lignes de sortie décalées chaque fois de j bits vers la gauche.

**5.** Filtre selon l'une quelconque des revendications précédentes, **caractérisé en ce que** pour réaliser une fonction de transfert $H(z^{-1})=\Sigma a_j z^{-j}$ avec j = 0, 1..., m-1, susceptible d'être représentée sous la forme d'un polynôme en $z^{-1}$, la chaîne com-

prend m additionneurs ($5_0$, $5_1$, $5_2$, $5_3$) et registres ($3_0$, $3_1$, $3_2$, $3_3$), l'entrée du registre d'ordre zéro ($3_0$) étant reliée au canal de données associé ($7_0$, $7_1$) et pour toutes les autres valeurs j>0 l'entrée du registre d'ordre j ($3_1$, $3_2$, $3_3$) est reliée à la sortie de l'additionneur d'ordre (j-1) ($5_0$, $5_1$, $5_2$).

6. Filtre selon la revendication 5,
   **caractérisé en ce que**
   pour toutes les $a_j \neq 1$ une entrée de l'additionneur d'ordre j ($5_0$, $5_1$, $5_2$, $5_3$) est reliée au canal de données correspondant ($7_0$, $7_1$) par un multiplicateur ($9_0$, $9_1$, $9_2$) pour multiplier avec le coefficient $a_j$.

7. Filtre selon l'une quelconque des revendications 1 à 5,
   **caractérisé en ce qu'**
   au moins un additionneur comporte deux entrées reliées aux sorties de deux registres appartenant au même groupe.

8. Filtre selon l'une quelconque des revendications précédentes,
   **caractérisé par**
   un commutateur qui relie la sortie d'un registre du groupe (i+1) modulo n (0≤i≤n-1) de manière sélective aux entrées des différents additionneurs en amont des registres du groupe i.

9. Filtre selon l'une quelconque des revendications précédentes,
   **caractérisé en ce qu'**
   un commutateur reliant l'entrée d'un additionneur en amont d'un registre du groupe (i+1) modulo n (0≤i≤n-1) est relié sélectivement en sortie de différents registres du groupe i.

10. Filtre selon l'une quelconque des revendications précédentes,
    **caractérisé par**
    un multiplexeur (fig. 10) à n entrées pour n suites de données (u, v, w) et n sorties auxquelles sont reliés chaque fois l'un des n canaux de données ($7_0$, $7_1$), le multiplexeur étant tel que les valeurs de données de l'une des suites de données soient émises en alternance cyclique entre les différents canaux de données ($7_0$, $7_1$).

11. Filtre selon l'une quelconque des revendications précédentes,
    **caractérisé par**
    un démultiplexeur relié à la sortie de l'un des additionneurs, et ayant n sorties qui forment chaque fois une sortie du filtre associée à l'une des suites de données.

12. Montage de filtres pour générer deux suites de données démodulées en quadrature à partir d'une suite d'origine commune et pour filtrer les suites générées,
    **caractérisé par**
    un filtre selon l'une des revendications 1 à 10, n = 2, deux multiplicateurs (17) qui reçoivent les valeurs de la suite d'origine, les multiplicateurs (17) étant prévus de façon que les valeurs reçues soient multipliées en alternance avec des coefficients sinus et cosinus et soient émises par les canaux de données ($7_0$, $7_1$).

13. Procédé de mise en oeuvre d'un filtre selon l'une quelconque des revendications 1 à 12 comprenant les étapes suivantes :

    a) pour tous les i=0,..., n-1, on applique une valeur de la suite de données d'ordre i au canal de données ($7_0$, $7_1$) du groupe (i+d) modulo n,
    b) on enregistre les valeurs appliquées aux premières entrées de tous les registres ($3_0$, $3_1$, $3_2$, $3_3$) dans les registres ($3_0$, $3_1$, $3_2$, $3_3$),
    c) on modifie d de la valeur 1, et
    d) on répète les étapes a)...c) aussi souvent que nécessaire.

14. Procédé selon la revendication 13,
    dans lequel
    les vitesses d'horloge de toutes les suites de données sont les mêmes.

15. Procédé selon la revendication 14,
    **caractérisé en ce qu'**
    on effectue n fois les étapes a)...c) dans chaque période d'horloge.

16. Procédé selon la revendication 14,
    **caractérisé en ce qu'**
    on effectue une fois les étapes a)...c) dans chaque période d'horloge des suites de données.

17. Application d'un filtre selon l'une quelconque des revendications 1 à 12 pour décimer en parallèle d'un facteur commun, n suites de données.

## FIG 1

## FIG 2

## FIG 3

## FIG 4

## FIG 5

## FIG 11

# FIG 6

Input → (X) 17 sin / (X) 17 cos → TP → 13

# FIG 7

$u_1, v_1, w_1, \cdots$

$9_m$ $a_m$ / $5_{m-1}$ / $5_{m-2}$ / $a_{m-3}$ $9_{m-3}$ / $a_0$ $9_0$

$z^{-1}$ $3_m$ $a_{m-1}$ / $z^{-1}$ $3_{m-1}$ / $z^{-1}$ $3_{m-3}$ / $5_0$

$7_0$ $5_{m-3}$

$\tilde{u}_1, \tilde{v}_1, \tilde{w}_1, \tilde{u}_4, \cdots$

$7_1$ $9_{m-1}$ $a_{m-2}$

$u_2, v_2, w_2, u_5, \cdots$

$7_2$ $9_{m-2}$

$u_3, v_3, w_3, u_6, \cdots$

# FIG 10

$u_1, u_2, \cdots$ — 31 — 31 — 36

$v_1, v_2, \cdots$ — 31 — 31 — 35 — 33

$w_1, w_2, \cdots$ — 31 — 31 — 34

$u_1, v_1, w_1, u_4, v_4, \cdots$

$u_2, v_2, w_2, u_5, w_5, \cdots$

$u_3, v_3, w_3, u_6, v_6, w_6, \cdots$

EP 1 018 216 B1

# FIG 8

# FIG 9